# EUROPÄISCHE PATENTSCHRIFT

(11) **EP 1 342 243 B1**
(45) Veröffentlichungstag und Bekanntmachung des Hinweises auf die Patenterteilung: **19.03.2008**
(21) Anmeldenummer: 01270888.9
(22) Anmeldetag: 03.12.2001
(51) Int. Cl.: G11C 11/22, H01L 27/115

(54) **SPEICHEREINRICHTUNG UND VERFAHREN ZU DEREN BETRIEB**
MEMORY DEVICE AND METHOD FOR THE OPERATION OF THE SAME
DISPOSITIF A MEMOIRE ET PROCEDE PERMETTANT DE LE FAIRE FONCTIONNER

(30) Priorität: 11.12.2000 DE 10061580
(43) Veröffentlichungstag der Anmeldung: 10.09.2003
(73) Patentinhaber: Infineon Technologies AG, 81669 München (DE)
(72) Erfinder: HOENIGSCHMID, Heinz, Essex Junction, VT 05452 (US); MUELLER, Gerhard, 86405 Meitingen (DE)
(74) Vertreter: Kottmann, Heinz Dieter
(86) Internationale Anmeldenummer: PCT/DE2001/004524
(87) Internationale Veröffentlichungsnummer: WO 2002/049035

(56) Entgegenhaltungen:
- US-A- 5 487 032
- US-A- 5 744 832
- US-A- 5 995 407
- US-A- 6 094 369

## Beschreibung

Die Erfindung betrifft eine Speichereinrichtung gemäß dem Oberbegriff des Anspruchs 1. Eine solche Speichereinrichtung ist bekannt aus US-A-5 995 407. Ein Herstellungsverfahren dazu ist aus US-A-5 744 832 bekannt.

Bei der Entwicklung moderner Speichertechnologien müssen gleichzeitig verschiedene, sich teilweise zunächst widersprechende Randbedingungen erfüllt werden, um einen effektiven Speicherbaustein zu konzipieren, der dann auch preisgünstig entwickelt und auf dem Markt verbreitet werden kann. Diese grundsätzlichen Anforderungen betreffen die geometrischen Ausdehnungen, die Schaltgeschwindigkeiten sowie die Komplexität des dann im Halbleitersubstrat zu realisierenden Layouts, welches dem jeweiligen Speicherbaustein oder der einzelnen Speicherzelle zugrundeliegt.

Speicherzellen sind in Speichereinrichtungen gewöhnlich in Matrixform angeordnet und werden durch das gleichzeitige Ansprechen über eine zugeordnete Zeilen- oder Wortleitung und eine zugeordnete Spalten- oder Bitleitung aktiviert, um ausgelesen und/oder beschrieben zu werden. Entsprechend der Aktivierung wird dann z.B. auf einen Kondensator oder dergleichen zugegriffen, welcher zur Informationsspeicherung ausgebildet ist. Der herkömmliche Zugriff erfolgt im Wesentlichen über einen Transistor, welcher mit dem Kondensator verbindbar oder verbunden ist, und zwar indem nach Aktivierung das auszulesende und Information tragende Signal auf dem Kondensator über einen entsprechenden Leseverstärker in der Spaltenleitung oder Bitleitung detektiert und entsprechend verstärkt wird, um dann als verstärktes Datensignal abgreifbar weitergeleitet zu werden.

Weitere Anforderungen an den Speichermechanismus, insbesondere das Ziel der Vereinfachung des Speichermanagements sowie der Wunsch nach dem Aufrechterhalten der Speicherinhalte unabhängig von einer Betriebsspannung, haben sogenannte nichtflüchtige Speichertechniken motiviert. Diese beruhen z.B. im Wesentlichen auf einem Hystereseprozess oder -effekt im Speicherelement oder Speicherkondensator. Ihren Niederschlag finden diese Aspekte zum Beispiel in der Entwicklung sogenannter FeRAM-Zellen, MRAM-Zellen oder dergleichen.

Speicherzellen vom nichtflüchtigen Typ, insbesondere FeRAM-Zellen oder dergleichen, sind üblicherweise zwischen einer der Spaltenleitungen oder Bitleitungen und einer zusätzlichen Ladeleitung, die auch als Plateleitung, "Plate" oder Plattenleitung bezeichnet wird, geschaltet. Diese Plateleitung ist gewöhnlich mit einer Treiberschaltung verbunden, durch welche die Plateleitung auf einem vorgegebenen Potential gehalten wird. Beim herkömmlichen Betrieb der Speichereinrichtung weisen die Spaltenleitungen oder Bitleitungen und die Ladeleitungen oder Plateleitungen der Speichereinrichtung jeweils eine aktive und eine inaktive Betriebsart oder einen solchen Zustand auf. Bei der aktiven Betriebsart, bei welcher zum Beispiel der Inhalt einer Speicherzelle ausgelesen wird, ist die entsprechende Spaltenleitung oder Bitleitung mit einem Leseverstärker verbunden. Die Plateleitung oder Ladeleitung liegt dabei an einem vorgegebenen Potential an. Bei der inaktiven Betriebsart sind die entsprechenden Spaltenleitungen oder Bitleitungen und die jeweiligen Ladeleitungen im allgemeinen mit einem Anschluss für ein gemeinsames Versorgungspotential verbunden, insbesondere um unbeabsichtigte Veränderungen des Speicherinhalts, beispielsweise durch Störungen oder dergleichen, zu vermeiden.

Trotz dieser Entwicklungen besteht dennoch weiterhin das Bedürfnis nach einer höheren Integration der einzelnen Speicherzellen im Halbleitersubstrat und nach der Verkürzung von Schaltzeiten. Gleichzeitig soll insgesamt zur Realisierung dieser Konzepte das Layout der jeweiligen Leitungen zu den einzelnen Speicherzellen im gesamten Speicherbaustein mit besonders geringem Flächenbedarf gestaltet sein.

Der Erfindung liegt die Aufgabe zugrunde, eine Speichereinrichtung zu schaffen, welche hinsichtlich des Speicherinhalts zuverlässig ansprechbar ist und welche gleichwohl ein besonders platzsparendes Layout zulässt.

Die Aufgabe wird vorrichtungsmäßig bei einer Speichereinrichtung der eingangs genannten Art erfindungsgemäß mit den kennzeichnenden Merkmalen des Anspruchs 1. Vorteilhafte Weiterbildungen sind jeweils Gegenstand der abhängigen Unteransprüche.

Die Lösung sieht vor, dass die Plateleitungseinrichtung zum Auslesen oder Abtasten der Kondensatoreinrichtung, insbesondere des elektromagnetischen und/oder ferroelektrischen Zustandes davon, ausgebildet ist, um auf die dort gespeicherte Information zuzugreifen.

Vorteilhaft ist es, dass die zweite Elektrode der Kondensatoreinrichtung und die Bitleitungseinrichtung im Wesentlichen aus demselben, vorzugsweise metallischen, Material ausgebildet sind. Dabei wird weiter bevorzugt, dass die zweite Elektrode der Kondensatoreinrichtung und die Bitleitungseinrichtung im Wesentlichen in demselben vertikalen Schichtbereich auf dem Halbleitersubstrat ausgebildet sind.

Dies bringt den Vorteil, dass beim schichtartigen Aufbau eines Speicherbausteins aus einer Mehrzahl erfindungsgemäßer Speichereinrichtungen der bisherige Produktionsprozess nicht grundsätzlich abgeändert werden muss.

Die häufig als sogenannte untere Elektrode oder Bottomelektrode ausgebildete zweite Elektrode der Kondensatoreinrichtung einer FeRAM-Zelle wird aus einem Metall, vorzugsweise aus Platin, im Rahmen einer bestimmten Produktionsstufe auf das Halbleitersubstrat aufgebracht. Durch die beschriebene Ausführungsform ist es möglich, gleichzeitig mit dem Aufbringen der zweiten oder Bottomelektrode auch die sogenannte Bitleitungseinrichtung oder Bitleitung im selben Produktionsschritt auf dem Halbleitersubstrat auszuführen, wobei die Verwendung desselben Materials sowohl produktionstechnische Vorteile liefert als auch elektrochemische Probleme vermeiden hilft. Es ist dann keine zusätzliche und/oder abweichende Metallisierungsschicht für die Bitleitung notwendig.

Produktionstechnisch besonders vorteilhaft ist die erfindungsgemäße Speichereinrichtung, wenn gemäß einer weiteren Ausführungsform die Plateleitungseinrichtung oder Plateleitung im Wesentlichen auf einem Oberflächenschichtbereich auf dem Halbleitersubstrat ausgebildet ist. Dabei wird unter einem Oberflächenschichtbereich z.B. eine Schicht verstanden, welche im Schichtaufbau im Wesentlichen obenauf angeordnet ist.

Im Hinblick auf die Flexibilität des Layouts und des Designs einer Anordnung aus einer Mehrzahl von erfindungsgemäßen Speichereinrichtungen in einem Speicherbaustein liefert das Anordnen der Plateleitung in einem Oberflächenbereich zusätzlich die Möglichkeit einer Entflechtung und Entzerrung von den üblicherweise vorgesehenen Bitleitungen und Wortleitungen. Des Weiteren können dann auch bereits vorhandene Schaltungslayouts auf besonders einfache Art und Weise übernommen werden, wobei dann die Plateleitungseinrichtungen in einem nachgeschalteten Strukturierungsvorgang auf bewährte Layouts quasi aufgesetzt werden können.

Besonders vorteilhaft ist eine Ausführungsform, bei welcher die ohnehin auszubildende erste Elektrode der Kondensatoreinrichtung im Bereich der Plateleitungseinrichtung und insbesondere als Teil davon ausgebildet ist. Somit wird beim Aufbringen der Metallisierungsschicht für die Plateleitung gleichzeitig auch die entsprechende Elektrode oder Kondensatorplatte für die Kondensatoreinrichtung der FeRAM-Zelle gefertigt.

Nachfolgend wird die Erfindung anhand einer schematischen Zeichnung auf der Grundlage bevorzugter Ausführungsbeispiele weiter erläutert.
- Fig. 1: zeigt die grundsätzliche Schaltungsanordnung für eine Ausführungsform der erfindungsgemäßen Speichereinrichtung.
- Fig. 2: zeigt die grundsätzliche Anordnung einer Mehrzahl gleichartiger erfindungsgemäßer Speichereinrichtungen in einem Speicherzellenfeld.
- Fig. 3: zeigt in einer Querschnittsansicht die Ausgestaltung einer Ausführungsform der erfindungsgemäßen Speichereinrichtung in einem Halbleitersubstrat.
- Fig. 4: zeigt eine Draufsicht auf das Layout zur Querschnittsdarstellung aus Fig. 3.
- Fig. 5: erläutert ein Betriebsverfahren zum Lesen/Schreiben auf einer erfindungsgemäßen Speichereinrichtung.

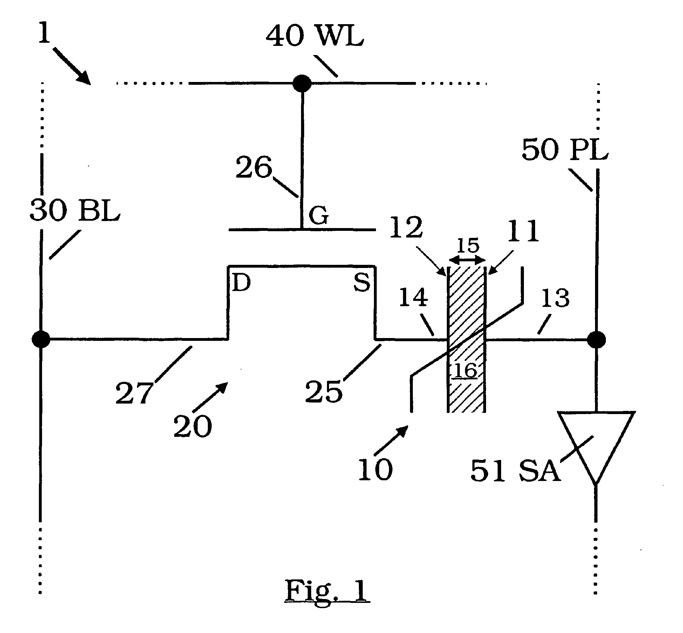

Fig. 1 zeigt schematisch eine Schaltungsanordnung für eine Ausführungsform der erfindungsgemäßen Speichereinrichtung 1.

Die Speichereinrichtung 1 ist als sogenannte FeRAM-Zelle ausgebildet. Sie weist einen Speicherkondensator 10 mit einer ersten Elektrode 11 und einer zweiten Elektrode 12 auf. Zwischen diesen ist ein Influenzbereich 15 gebildet wird, der seinerseits mit einem Influenzmedium 16 gefüllt ist.

Des weiteren weist die Speichereinrichtung 1 einen Feldeffekttransistor als Zugriffstransistor 20 mit einem Sourcebereich S, einem Drainbereich D und einen Gatebereich G auf. Über einen ersten Anschlussbereich 25 ist der Sourcebereich S des Zugriffstransistors 20 mit dem zweiten Anschluss 14 des Speicherkondensators 10 und insbesondere mit dessen zweiter Elektrode 12, der unteren Elektrode, verbunden.

Zum Zugriff auf die Speichereinrichtung 1 sind eine Spalten- oder Bitleitung 30 und eine Zeilen- oder Wortleitung 40 vorgesehen. Die Bitleitung 30 ist über den dritten Anschluss 27 mit dem Drainbereich D des Zugriffstransistors 20 verbunden. Die Wortleitung 40 ist über den zweiten Anschlussbereich 26 mit dem Gatebereich G des Zugriffstransistors 20 verbunden.

Zum Zugreifen auf den Speicherinhalt, welcher durch den elektromagnetischen, inbesondere ferroelektrischen Zustand des Influenzmediums 16 im Influenzbereich 15 repräsentiert wird, ist erfindungsgemäß die Plateleitung 50 mit einer Leseverstärkereinrichtung 51 (SA, Senseamplifier) verbunden, durch welchen das abgegriffene Signal identifiziert und zur Weiterleitung verstärkt wird. Die Plateleitung 50 ist über den ersten Anschluss 13 des Speicherkondensators 10 mit dessen erster Elektrode 11, der oberen Elektrode verbunden.

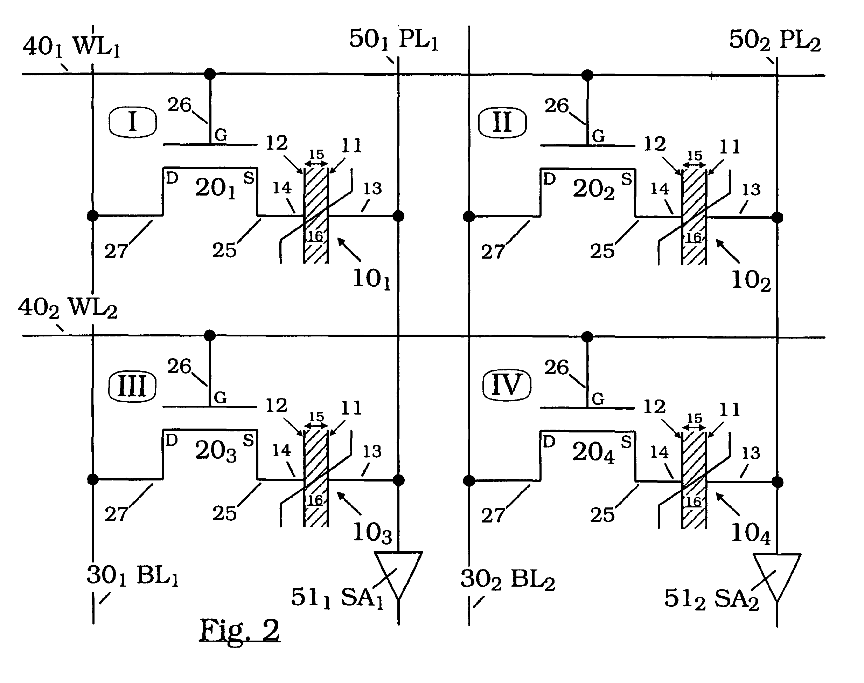

Die Figur 2 zeigt in Form eines schematischen Schaltbildes die Anordnung eines Zellenfeldes 100 mit einer Mehrzahl, nämlich vier, verschalteter erfindungsgemäßer Speichereinrichtungen I bis IV, die einen identischen Aufbau besitzen. Jede der erfindungsgemäßen verschalteten Speicherzellen I bis IV weist als FeRAM-Zelle einen Speicherkondensator 10₁, ..., 10₄ auf, auf welche jeweils mittels Zugriffstransistoren 20₁, ..., 20₄ zugegriffen wird. Die Zugriffstransistoren 20₁, ..., 20₄ werden über Wortleitungen 40₁ und 40₂ sowie Bitleitungen 30₁ und 30₂ angesprochen und aktiviert. Die Speicherkondensatoren 20₁, ..., 20₄ sind mit jeweils einem Anschluss mit einer Plateleitung 50₁ oder 50₂ und mit ihrer anderen Elektrode mit dem jeweiligen Zugriffstransistor 20₁, ..., 20₃ verbunden. Die Plateleitungen 50₁ und 50₂ weisen zum Abtasten, Erfassen und Verstärken der abgegriffenen Signale Leseverstärker 51₁ und 51₂ auf.

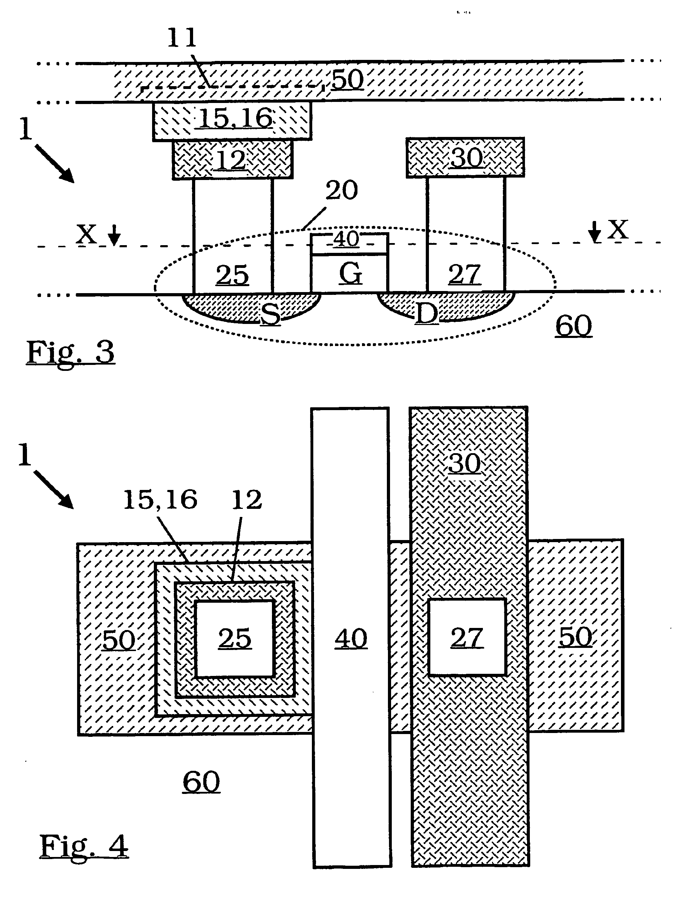

Fig. 3 zeigt in Form einer geschnittenen Darstellung die Ausbildung einer Ausführungsform der erfindungsgemäßen Speichereinrichtung 1 auf einem Halbleitersubstrat 60.

Im oberen Bereich des Halbleitersubstrats 60 sind der Sourcebereich S und der Drainbereich D des Zugriffstransistors 20 zum Beispiel als n⁺-dotierte Bereiche im Halbleitersubstrat 60 ausgebildet. In der darüber aufgebrachten Schicht auf dem Halbleitersubstrats 60 ist in der Mitte zunächst der Gatebereich G des Zugriffstransistors 20 ausgebildet. Auf diesem ist direkt eine Schicht aufgebracht, die ihrerseits die sogenannte Wortleitung 40 bildet, welche sich lateral im Halbleitersubstrat 60 erstreckt, also in die Zeichnungsebene der Fig. 2 hinein.

An den Sourcebereich S und an den Drainbereich D schließen sich ein erster und ein dritter Anschlussbereich 25 bzw. 27 an, z. B. in Form sogenannter Plugs. Diese sind mit der unteren oder zweiten Elektrode 12 des Kondensators 10 bzw. mit der Bitleitung 30 verbunden. Ersichtlich ist, dass die untere oder zweite Elektrode 12 des Kondensators 10 und die Bitleitung 30 aus demselben Material, nämlich Platin, gefertigt sind und im selben Schichtbereich auf dem Halbleitersubstrat 60 aufstrukturiert sind. Dabei kann die Bitleitung 30 gegebenenfalls auch als Diffusionsbereich oder dergleichen geführt werden.

Oberhalb der unteren oder zweiten Elektrode 12 des Kondensators 10 ist der Influenzbereich 15 ausgebildet, welcher mit dem Influenzmedium 16 versehen ist. Oberhalb des Influenzbereiches 15 erstreckt sich von links nach rechts die sogenannte Plateleitung 50 in Form einer aufgebrachten Metallisierungsschicht, wobei diese Plateleitung 50 auch gleichzeitig die obere oder erste Elektrode 11 des Kondensators 10 bildet und mit dem Leseverstärker 51 verbunden ist.

Die Fig. 4 zeigt eine Layoutdraufsicht der Anordnung aus Fig. 3, und zwar entlang der Schnittfläche X-X.

Im Zusammenhang zwischen den Fig. 3 und 4 wird deutlich, dass die Wortleitung 40 und die Bitleitung 30 in etwa parallel zueinander verlaufen, und zwar in verschiedenen Schichtbereichen auf dem Halbleitersubstrat 60. Quer dazu verläuft die Plateleitung 50, und zwar in dem in Fig. 3 und 4 gezeigten Ausführungsbeispiel in einem zuoberst angeordneten Schichtbereich auf dem Halbleitersubstrat 60.

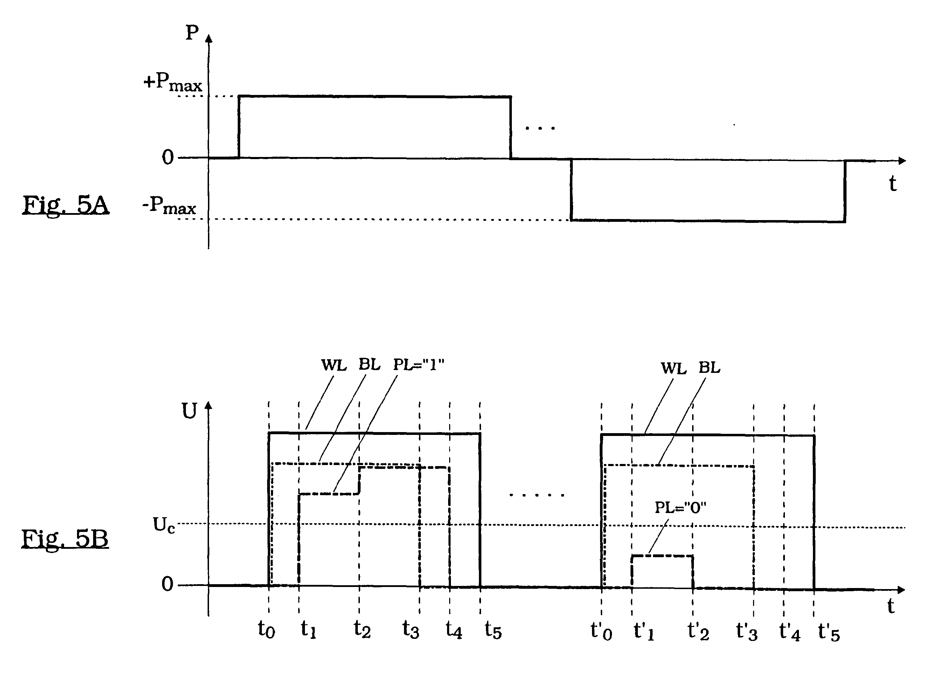

Die Fig. 5A und 5B zeigen in Form von Graphen die zeitlichen Verläufe verschiedener Signale, die bei einer Ausführungsform der erfindungsgemäßen Speichereinrichtung auftreten und aus denen eine mögliche Betriebsart der erfindungsgemäßen Speichereinrichtung deutlich wird.

Fig. 5A zeigt den zeitlichen Verlauf des elektromagnetischen oder ferroelektrischen Zustands, nämlich der elektrischen Polarisation P des Influenzmediums 16 des Speicherkondensators 10 der erfindungsgemäßen Speichereinrichtung 1. Je nach Polarisation P des Influenzmediums 16 im Influenzbereich 15 des Kondensators 10 sei definitionsgemäß der Speicherinhalt "0" bzw. "1" realisiert. Die Polarisation P variiert mit der Zeit t, so dass in einem ersten Zeitbereich eine logische "1" und in einem zweiten Zeitbereich eine logische "0" dargestellt ist.

Fig. 5B zeigt die zeitlichen Verläufe der Spannungen WL (Wortleitungsspannung), BL (Bitleitungsspannung) und PL (Plateleitungsspannung) der Wortleitung 40, der Bitleitung 30 sowie der Plateleitung 50 der erfindungsgemäßen Speichereinrichtung 1.

Zum Zeitpunkt t₀ wird die erfindungsgemäße Speichereinrichtung 1 durch Hochsetzen der Wortleitungsspannung WL und der Bitleitungsspannung BL aktiviert, um ausgelesen zu werden. Zeitlich versetzt entwickelt sich dann zum Zeitpunkt t₁, dem Beginn der Signalentwicklung, auf der Plateleitung 50 der durch den Polarisationszustand P des Influenzmediums 16 beeinflusste Signalpegel. Im Vergleich zu einem Vergleichspegel U_{c} ergibt sich aufgrund der Polarisation-P ein erhöhter Pegel, und die Plateleitungsspannung PL wird zum Zeitpunkt t₂, dem Zeitpunkt des Abtastens und Verstärkens, durch den Leseverstärker 51 "high" gesetzt, was dem Speicherinhalt "1" entspricht. Zum Zeitpunkt t₃ wird die Bitleitung BL deaktiviert, um die gelesene Information wieder in die Speicherzelle zurückzuschreiben. Der Rückschreibeprozess ist mit dem Abschalten des Verstärkers bei t₄ beendet. Zum Zeitpunkt t₅ wird mit Abschalten der Wortleitungsspannung WL die Speicherzelle deaktiviert, wobei aber der Informationsgehalt im Influenzmedium 16 aufgrund des nichtflüchtigen Hystereseprozesses erhalten bleibt.

Für den nachfolgenden Betriebsabschnitt wird vorausgesetzt, dass sich das Influenzmedium 16 im entgegengesetzten Polarisationszustand P befindet, durch welchen eine logische "0" als Speicherinhalt repräsentiert wird.

Zum Zeitpunkt t'₀ wird die erfindungsgemäße Speichereinrichtung 1 wiederum durch Hochsetzen der Wortleitungsspannung WL und der Bitleitungsspannung BL aktiviert. Zeitlich etwas verzögert zum Zeitpunkt t'₁ wird dann der Signalpegel auf der Plateleitung 50 ausgelesen, welcher wiederum durch den Polarisationszustand P des Influenzmediums 16 beeinflusst ist. Aufgrund der entgegengesetzten Polarisation (einen "0"-Zustand repräsentierend) fällt der Signalpegel unterhalb der Vergleichsspannung U_{c} ab und wird dann zum Zeitpunkt t'₂ durch den Leseverstärker "low" gesetzt, wodurch auf der Plateleitung 50 als entsprechender Wert eine logische "0" erscheint.

Wesentlich an der Vorgehensweise beim Betrieb der erfindungsgemäßen Speichereinrichtung ist unter anderem, dass beim Auslesen der gespeicherten Information aus der erfindungsgemäßen Speichereinrichtung 1 ein zeitlich vorübergehendes Hochsetzen der Bitleitung 30 mit dem entsprechenden Bitleitungssignal BL möglich ist.

Dieser Pulsbetrieb schafft im Hinblick auf den aufzubringenden Zeitaufwand und auch in organisatorischer Hinsicht Vorteile und ist hier zum ersten Mal deshalb möglich, weil die Bitleitung 30 aus dem gleichen Material ausgebildet ist wie die untere zweite Elektrode 12 des Kondensators 10. Erst die niederohmige Ausgestaltung der Bitleitung 30 ermöglicht in vorteilhafter Weise pulsweisen Betrieb auf der Bitleitung 30.

Zusammenfassend ergeben sich als einige wesentliche Aspekte der erfindungsgemäßen Speichereinrichtung sowie des Verfahrens zum Betrieb einer Speichereinrichtung, dass eine vorhandene Plateleitungseinrichtung zum Abtasten oder Auslesen der Information des Speicherkondensators oder dergleichen ausgebildet ist und dazu insbesondere mit einem entsprechenden Leseverstärker oder Senseamplifier verbunden ist, dass ferner die vorhandene Bitleitungseinrichtung um etwa in demselben vertikalen Schichtbereich der unteren Kondensatorelektrode oder Bottomelektrode und/oder aus demselben Material wie die Bottomelektrode ausgeführt ist. Aufgrund des Layouts und des Materialdesigns ergibt sich die Möglichkeit eines gepulsten Betriebes, insbesondere auf der Bitleitungseinrichtung, und zwar ohne Zeitverlust durch Reduzierung der Zeitkonstante der Anstiegsflanke des Bitleitungspotentialpulses durch die entsprechend niederohmig ausgebildete Bitleitungseinrichtung.

### Bezugszeichenliste

- 1: Speichereinrichtung
- 10: Kondensatoreinrichtung, Speicherkondensator
- 11: erste, obere Elektrode
- 12: zweite, untere Elektrode
- 13: erster Anschluß
- 14: zweiter Anschluß
- 15: Influenzbereich
- 16: Influenzmedium
- 20: Transistoreinrichtung, Zugriffstransistor
- 25: erster Anschlußbereich
- 26: zweiter Anschlußbereich
- 27: dritter Anschlußbereich
- 30: Bitleitungseinrichtung, Bitleitung
- 40: Wortleitungseinrichtung, Wortleitung
- 50: Plateleitungseinrichtung, Plateleitung
- BL: Bitleitungsspannung
- D: Drainbereich
- G: Gatebereich
- P: Polarisationszustand
- S: Sourcebereich
- U_{c}: Vergleichspegel
- WL: Wortleitungsspannung
- X: Schnittlinie

## Patentansprüche

1. Speichereinrichtung mit
- mindestens einer Kondensatoreinrichtung (10), welche zur Speicherung von Information auf der Grundlage eines Hystereseprozesses ausgebildet ist und welche dazu eine erste und eine zweite Elektrode (11, 12), damit verbundene erste und zweite Anschlüsse (13, 14) sowie einen zwischen den Elektroden (11, 12) vorgesehenen Influenzbereich (15) mit einem Influenzmedium (16) aufweist,
- mindestens einer Transistoreinrichtung (20), welche zum Zugriff auf die Kondensatoreinrichtung (10) ausgebildet ist und welche dazu mit der Kondensatoreinrichtung (10) und eines Bitleitungseinrichtung (30) verbindbar ausgebildet ist, und
- mindestens einer Plateleitungseinrichtung (50), welche über einen freien Anschluss (13) mit der Kondensatoreinrichtung (10) elektrisch leitend verbindbar und zum Abtasten des elektromagnetischen Zustands der Kondensatoreinrichtung (10) mit einer Leseverstärkereinrichtung (51) ausgebildet ist, um auf die dort gespeicherte Information zuzugreifen,
**dadurch gekennzeichnet, dass**
- die zweite Elektrode (12) der Kondensatoreinrichtung (10) und die Bitleitungseinrichtung (30) aus demselben metallischen Material und in demselben vertikalen Schichtbereich eines Halbleitersubstrats (60) ausgebildet sind und
- die erste Elektrode (11) der Kondensatoreinrichtung (10) im Bereich der Plateleitungseinrichtung (50) und als Teil davon ausgebildet ist.

2. Speichereinrichtung nach Anspruch 1,
welche als FeRAM-Zelle oder als MRAM-Zelle ausgebildet ist.

3. Speichereinrichtung nach einem der vorangehenden Ansprüche,
**dadurch gekennzeichnet,**
**dass** die Transistoreinrichtung (20) als Feldeffekttransistor ausgebildet ist und einen Source-, Drain- und einen Gatebereich (S, D, G) aufweist, welche jeweils mit ersten Enden vorgesehener erster, zweiter bzw. dritter Anschlussbereiche (25, 26, 27) elektrisch leitend verbindbar ausgebildet sind, wobei das zweite Ende des ersten Anschlussbereichs (25) mit dem zweiten Anschluss (14) der Kondensatoreinrichtung (10) verbindbar ausgebildet ist.

4. Speichereinrichtung nach Anspruch 3,
**dadurch gekennzeichnet,**
**dass** eine Bitleitungseinrichtung (30) vorgesehen ist, welche über den dritten Anschlussbereich (27) mit dem Drainbereich (D) der Transistoreinrichtung (20) elektrisch leitend verbindbar ist und welche ausgebildet ist, im Betrieb mit einer Mehrzahl weiterer Speichereinrichtungen (1) kontaktiert zu werden.

5. Speichereinrichtung nach einem der vorangehenden Ansprüche,
**dadurch gekennzeichnet,**
**dass** eine Wortleitungseinrichtung (40) vorgesehen ist, welche über den zweiten Anschlussbereich (26) mit dem Gatebereich (G) der Transistoreinrichtung (20) elektrisch leitend verbindbar ist und welche ausgebildet ist, im Betrieb mit einer Mehrzahl weiterer Speichereinrichtungen (1) kontaktiert zu werden.

6. Speichereinrichtung nach einem der vorangehenden Ansprüche,
**dadurch gekennzeichnet,**
**dass** als Influenzmedium (16) SrBi₂Ta₂O₉ als ein ferroelektrisches Medium vorgesehen ist.

7. Speichereinrichtung nach einem der vorangehenden Ansprüche,
**dadurch gekennzeichnet,**
- **dass** die Speichereinrichtung (1) zumindest als Teil einer integrierten Schaltung in oder auf einem Halbleitersubstrat (60) ausgebildet ist und
- **dass** die Kondensatoreinrichtung (10) als vertikal angeordneter Schichtaufbau ausgebildet ist.

8. Speichereinrichtung nach einem der vorangehenden Ansprüche,
**dadurch gekennzeichnet,**
**dass** die Plateleitungseinrichtung (50) in einem Oberflächenschichtbereich auf dem Halbleitersubstrat (60) ausgebildet ist.

## Claims

1. Memory device having
- at least one capacitor device (10), which is designed for storing information on the basis of a hysteresis process and which has for this purpose a first and a second electrode (11, 12), first and second terminals (13, 14) connected thereto, and also an influence region (15) with an influence medium (16) provided between the electrodes (11, 12),
- at least one transistor device (20), which is designed for access to the capacitor device (10) and which is designed for this purpose such that it can be connected to the capacitor device (10) and to a bit line device (30), and
- at least one plate line device (50), which can be electrically conductively connected to the capacitor device (10) via a free terminal (13) and is designed for sensing the electromagnetic state of the capacitor device (10) with a sense amplifier device (51) in order to access the information stored there,
**characterized**
- **in that** the second electrode (12) of the capacitor device (10) and the bit line device (30) are formed from the same metallic material and in the same vertical layer region of a semiconductor substrate (60) and
- the first electrode (11) of the capacitor device (10) is formed in the region of the plate line device (50) and as part thereof.

2. Memory device according to Claim 1,
which is designed as an FeRAM cell, MRAM cell or the like.

3. Memory device according to one of the preceding claims,
**characterized**
**in that** the transistor device (20) is designed as a field-effect transistor and has a source region, drain region and a gate region (S, D, G), which are designed such that they can respectively be electrically conductively connected to first ends of first, second and third terminal regions (25, 26, 27) provided, the second end of the first terminal region (25) being designed such that it can be connected to the second terminal (14) of the capacitor device (10).

4. Memory device according to Claim 3,
**characterized**
**in that** a bit line device (30) is provided, which can be electrically conductively connected to the drain region (D) of the transistor device (20) via the third terminal region (27) and which is designed to become contact-connected to a plurality of further memory devices (1) during operation.

5. Memory device according to one of the preceding claims,
**characterized**
**in that** a word line device (40) is provided, which can be electrically conductively connected to the gate region (G) of the transistor device (20) via the second terminal region (26) and which is designed, in particular, to become contact-connected to a plurality of further memory devices (1) during operation.

6. Memory device according to one of the preceding claims,
**characterized**
**in that** SrBi₂Ta₂O₉ as a ferroelectric medium is provided as the influence medium (16).

7. Memory device according to one of the preceding claims,
**characterized**
- **in that** the memory device (1) is designed at least as part of an integrated circuit in or on a semiconductor substrate (60) or the like, and/or
- **in that** the capacitor device (10) is formed as a layer construction arranged essentially vertically.

8. Memory device according to one of the preceding claims,
**characterized**
**in that** the plate line device (50) is formed in a surface layer region on the semiconductor substrate (60).

## Revendications

1. Dispositif de mémoire comprenant
- au moins un dispositif (10) de condensateur, qui est formé pour mémoriser de l'information sur là base d'un processus d'hystérésis et qui a, à cet effet, une première et une deuxième électrode (11, 12), des première et deuxième bornes (13, 14) ainsi reliées, ainsi qu'une zone (15) d'influence prévue entre les électrodes (11, 12) et ayant un milieu (16) d'influence,
- au moins un dispositif (20) de transistor, qui est formé pour accéder au dispositif (10) de condensateur et qui, à cet effet, est constitué de manière à pouvoir être relié au dispositif (10) de condensateur et à un dispositif (30) de lignes de bit, et
- au moins un dispositif (50) de lignes de plaque, qui peut être relié de manière conductrice de l'électricité au dispositif (10) de condensateur par une borne (13) libre et qui est constitué, pour la détection de l'état électromagnétique du dispositif (10) de condensateur, d'un dispositif (51) amplificateur de lecture pour accéder à l'information qui y est mémorisée,
**caractérisé en ce que**
- la deuxième électrode du dispositif (10) de condensateur et le dispositif (30) de lignes de bit sont en le même matériau métallique et sont dans la même partie de couche verticale d'un substrat (60) semi-conducteur et
- la première électrode (11) du dispositif (10) de condensateur est constituée dans la zone du dispositif (50) de lignes de plaques et en fait partie.

2. Dispositif de mémoire suivant la revendication 1,
qui est constitué sous la forme d'une cellule FeRAM ou d'une cellule MRAM.

3. Dispositif de mémoire suivant l'une des revendications précédentes,
**caractérisé en ce que** le dispositif (20) de transistor est constitué sous la forme d'un transistor à effet de champ et a une zone (S) de source, une zone (D) de drain et une zone (G) de grille, qui peuvent être reliées respectivement d'une manière conductrice de l'électricité à des première, deuxième et troisième zones (25, 26, 27) de borne munies de premières extrémités, la deuxième extrémité de la première zone (25) de borne pouvant être reliée à la deuxième borne (14) du dispositif (10) de condensateur.

4. Dispositif de mémoire suivant la revendication 3,
**caractérisé en ce qu'**il est prévu un dispositif (30) de lignes de bit, qui peut être relié d'une manière conductrice de l'électricité à la zone (D) de drain du dispositif (20) de transistor par la troisième zone (27) de borne et qui est constitué pour être mis en contact en fonctionnement avec une multiplicité d'autres dispositifs (1) de mémoire.

5. Dispositif de mémoire suivant l'une des revendications précédentes,
**caractérisé en ce qu'**il est prévu un dispositif (40) de lignes de mot, qui peut être relié d'une manière conductrice de l'électricité à la zone (G) de grille du dispositif (20) de transistor par la deuxième zone (26) de borne et qui est constitué de manière à être mis en contact en fonctionnement avec une multiplicité d'autres dispositifs (1) de mémoire.

6. Dispositif de mémoire suivant l'une des revendications précédentes,
**caractérisé en ce qu'**il est prévu comme milieu (16) d'influence du SrBi₂Ta₂O₉ comme milieu ferroélectrique.

7. Dispositif de mémoire suivant l'une des revendications précédentes,
**caractérisé en ce que**
- le dispositif (1) de mémoire est constitué au moins en partie d'un circuit intégré dans ou sur un substrat (60) semi-conducteur et
- le dispositif (10) de condensateur est constitué sous la forme d'une structure stratifiée disposée verticalement.

8. Dispositif de mémoire suivant l'une des revendications précédentes,
**caractérisé en ce que** le dispositif (50) de lignes de plaque, est formé dans une partie de couches superficielles sur le substrat (60) semi-conducteur.
